# EUROPEAN PATENT SPECIFICATION

(11) **EP 2 944 967 B1**
(45) Date of publication and mention of the grant of the patent: **05.08.2020**
(21) Application number: 14001713.8
(22) Date of filing: 15.05.2014
(51) Int. Cl.: G01R 19/00

(54) **Impedance matching element for voltage and/or current sensing devices**
Impedanzanpassungselement für Spannungs- und/oder Strommessvorrichtungen
Élément d'adaptation d'impédance pour la tension et/ou les dispositifs de détection de courant

(43) Date of publication of application: 18.11.2015
(73) Proprietor: ABB Schweiz AG, 5400 Baden (CH)
(72) Inventor: Sevcik, Bretislav, 628 00 Brno (CZ); Velesik, Petr, 602 00 Brno (CZ); Javora, Radek, 664 62 Hrusovany u Brna (CZ)
(74) Representative: Maiwald Patent- und Rechtsanwaltsgesellschaft mbH

(56) References cited:
- EP-A1- 2 722 678
- FR-A1- 2 698 696
- US-A1- 2009 309 605
- US-A1- 2010 156 441

## Description

The invention is related to suggestion of impedance matching element which can be used for voltage and/or current sensing or indicating devices used in medium voltage systems in order to improve signal integrity of output signal in comparison with conventional sensing devices.

FR2698696A1 describes that a device uses a capacitive voltage divider, with each phase having a first capacitor connecting the line conductor to a measuring point, and a second capacitor connecting the measuring point to earth. The first capacitor is formed by the connection of the detector to the line, using the line insulation as dielectric and the line conductor and a metal pin in the connector as electrodes. The second capacitor is formed by an insulating disc placed between the line connector and the coaxial cable that connects the centre of the capacitive voltage divider to the electronic interface circuit.

US2010/0156441A1 describes that a multilayer capacitive divider comprises a first and second main electrode formed on the same level to apply an input voltage, and a common electrode formed on another level to supply an attenuated voltage, said device comprising at least a first auxiliary electrode formed on yet another level, said electrodes being arranged so as to form capacitive units, said auxiliary electrode extending towards a side of said device towards which the second main electrode is arranged so as to connect said auxiliary electrode to the second main electrode by means of a linear conductor.

The sensing devices are based on several principles where measuring accuracy each of them is more or less dependent on the characteristic of signal transmission path and parameters of input circuits of measuring device such us a relays, measuring units etc. Thus, the load impedance mismatch, variation of additional stray or parasitic capacitances might influence the measuerement accuracy of MV instrument transformers. It can also results in high sensitivity towards external electric and/or magnetic fields. In such cases, it is necessary to adapt signal output of sensing device for each type of measuring device separately or special filter circuits at the input side of measuring device in order to ensure sufficient signal integrity must be used.

Present means for elimination the impairments described above includes design of output impedances of sensign devices close to the input impedances of measuring devices or correction setting directly in measuring device. This solutions becomes impractical with increasing number of measuring devices with different input circuit parameters. Usual practice is to use either of the solutions:
1) Proper output impedance design - this solution is used in cases where more than just one type of measurement device is used. It is highly impractical because of various output impedance designs are used for each of the measuring devices and special instructions to avoid the sensing device damage due to the design confusion must be observed.
2) Correction setting of measuring device - this solution is used separately or together with impedance design described above. The measured values can be adjusted (corrected) in a certain range due to the offset function in measuring device. If we consider various output impedances of sensing devices the correction settings must be performed for each of them. In case that different lengths of connecting cables are used, an additional time for the configuration of measuring device for certain variants is required.
3) Correction using additional passive components - in certain cases additional corrections to improve sensing device accuracy are performed by using external passive components as capacitors or resistors. However, the solution is still tailored to the specific applications.

The above-described methods to improve signal integrity of sensing devices and measuring accuracy shows that for more variability of these devices additional complexities in their configuration before or after measuring are required. Moreover, in the case of using only one signal from sensing device to multiple devices in the same time there are no satisfactory solution yet. All the above problems are solved by using impedance matching element described below.

Therefore it is the object of the invention, to enhance the sensing accuracy and result a higher output signal immunity against interferences and impedance mismatches, and this realized in a compact and constructional effectice way.

The main feature combination of the invention which follows this desired functional requirement is, that the electric field sensor and/or the magnetic field sensor is connected to the impedance matching element which allows connection to independent analogue measuring device and is powered from energy harvester, providing stable power supply to the impedance matching element, being integral part of impedance matching electronic board.

In an aspect, there is provided a current and/or voltage sensing device for integrative use in electric systems as defined in appended claim 1.

In a further advantageous embodiment,
the energy harvester is powered from magnetic field and/or electric field sensor.
or alternatively
powered from external power source.

In a further advantageous embodiment, the impedance matching element provide output proportional to the measured quantities, such as electric and/or magnetic field, and is independent on the input impedance of the connected device.

In a further advantageous embodiment,
the impedance matching element is capable of further conditioning of output signals.

Further advantageous is, that
the impedance matching element is capable of providing digital output.

In a further advantageous embodiment,
the impedance matching element is connected with output cable of said device.

Furthermore, the impedance matching element can be connected not only with new devices produced, but also with existing sensing devices already installed in the applications, thus suitable for retrofit purposes.

Advantageous is, that in a further embodiment,
the impedance matching element is having internal monitoring and/or diagnostics of its functions.

In a final advantageous embodiment,
the energy harvester is powered from electric field sensor designed by capacitive voltage divider.

This invention proposes the use of modern low-power devices, together referred as impedance matching element that helps to improve signal integrity and measuring accuracy of sensing devices, without the necessity to use external power source. Due to its high variability it can be used with existing sensing devices, where current sensing device, in one preferred embodiment, considers the use of Rogowski coil technology, that enables the use of one single device for the wide range of measured currents and that enables to significantly reduce size of current sensing element. As such current sensing device does not contain any ferromagnetic core, it will be very light-weighted, as well as compact, and therefore effective in the construction.

Voltage sensing device could utilize either capacitive and/or resistive voltage divider technology. This technology also enables significant size and weight reduction, still achieving very good sensing accuracy. As both current and voltage sensing technologies enables creation of very small devices, it is easily possible to combine them into one single device together with independent power source for impedance matching element. This possibility is utilized in proposed construction of small sized combined current/voltage sensing device with integrated additional electrodes for harvesting system wchich is part of impedance matching element.

Thus a prefered advantageous embodiment is, that the current sensor, voltage sensor and electrodes for harvesting system are implemented together in one common, for example toroidal sensor housing in that way, that the current sensor coil is arranged in the middle between the voltage electrodes and electrodes for harvesting, see detailed description below. However, using of impedance matching element is not limited to existing sensing devices already installed in the applications but can be easily connected with new produced devices, with at least one magnetic field sensor and/or at least one electric field sensor.

Embodiments of the invention are shown in the figures.

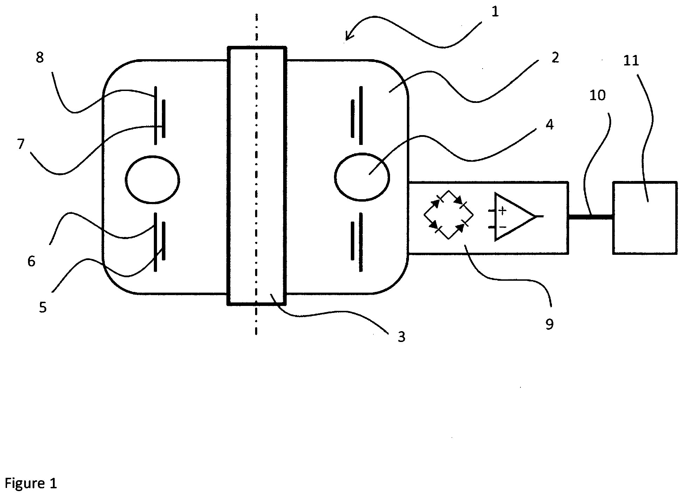

- Figure 1:: combined current/voltage sensing device with harvesting system
- Figure 2:: Location of harvesting system if non-conventional power sources are used
- Figure 3:: Location of harvesting system if non-conventional power sources are used
- Figure 4:: Location of harvesting system if conventional power sources are used
- Figure 5:: Harvesting system dimensions
- Figure 6:: Phase variation of conventional sensing devices vs. load impendances
- Figure 7:: Amplitude and phase error reduction by using proposed sensing device

Combined sensing device 1 consists of insulating material 2, that provides sufficient dielectric strength, depending on the voltage level applied on primary conductor 3. Current sensing part 4 senses magnetic field that is proportional to the current flowing through the primary conductor 3. Voltage sensing part consists of primary capacitance created between primary conductor 3 and capacitive electrode 5 and secondary capacitance created between capacitive electrode 5 and shielding electrode 6. Shielding electrode 6 protect capacitive electrode 5 from external electric fields, thus shielding from external disturbances. In case division ratio of capacitances created between primary conductor 3, capacitive electrode 5 and shielding electrode 6 is not sufficient to create required ratio, external capacitors could be electrically connected in parallel to the output of such voltage divider to tune the divider ratio to required level. Part for harvesting consist of primary capacitance created between primary conductor 3 and capacitive electrode 7 and secondary capacitance created between capacitive electrode 8. The required ratio is achieved by using external capacitor similarly as described above. The harvesting system 9 is a part of the cable connection 10 that connects the sensing device with a measuring device.

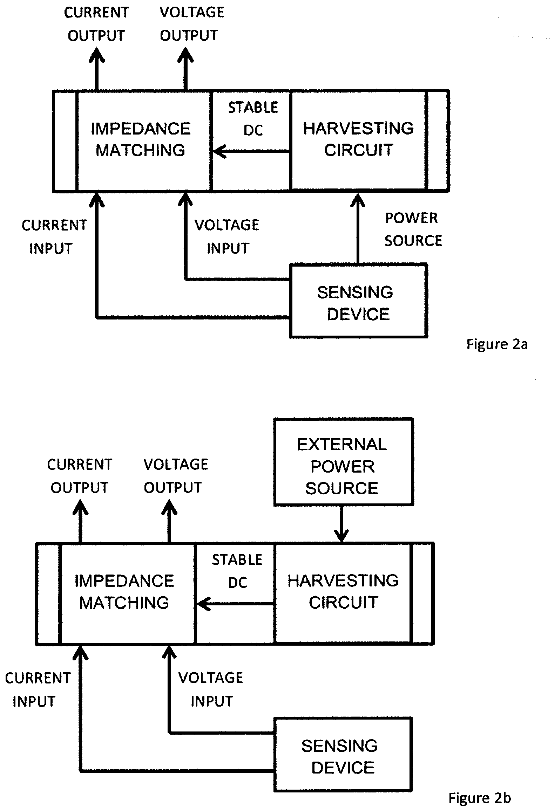

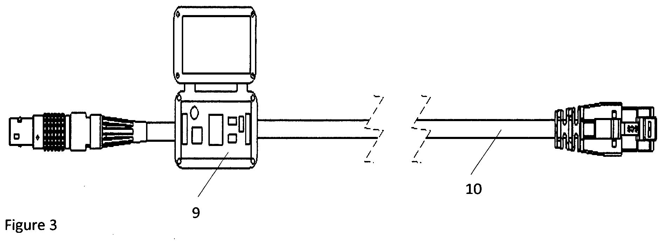

Due to the variability of harvesting system simple configuration of output voltage for supply of active electronic is possible for example for four voltage DC levels 1.8V, 2.5V, 3.3V and 3.6V. Thus, all usual voltage levels for modern low-power integrated circuits are available. The system consist of automatic voltage clamping regulation so the output voltage stability is ensured. Proposed system also excels in wide variety of usable input power sources depending on the type of ambient energy available. In this case piezoelectric elements, electric field, thermoelectric energy, solar energy, DC or AC conventional voltage source can be used. Possible system configurations are shown in Fig. 2a for version with internal supply and in Fig. 2b for version with external power source. The impedance matching element is capable of further conditioning of output signals. Thus, additional signal adjustment such as integration can be performed. Based on the devices configuration in impedance matching element, an analog or a digital output can be provided. Based on the selected input power source, the harvesting system 9 is placed in cable connection 10 according to Fig. 3, if non-conventional power source are used (internal supply, see Fig. 2a).

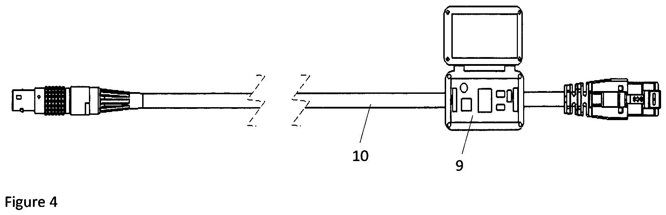

Due to the usability of both AC or DC votage source the harvesting system can be powered directly from measured device. In this case the harvesting system 9 is placed in cable connection 10 according to Fig. 4 (external poer source, see Fig. 2b).

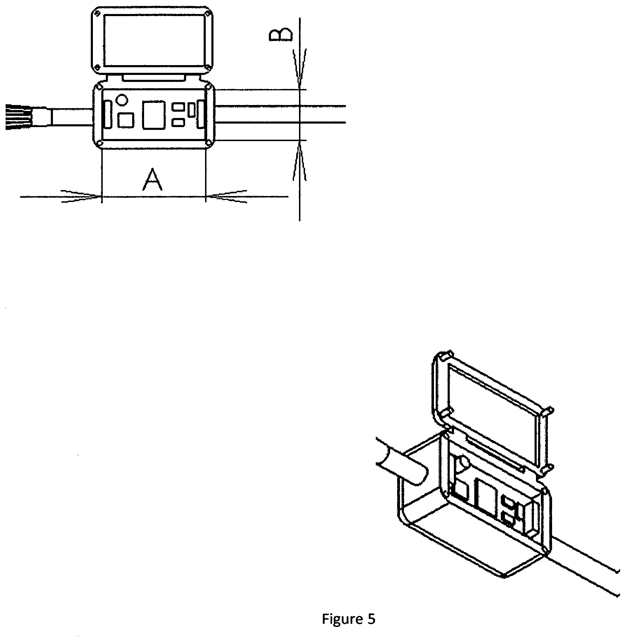

Dimensions of entire system due to the using of modern integrated circuits are reduced to less than 40 mm in length A and less than 20 mm in height B, see Fig. 5.

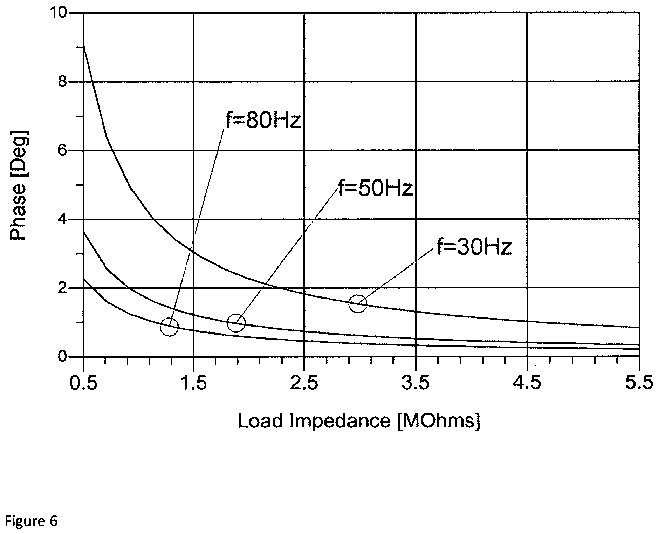

Biggest advantage of the proposed solution is in product application where measuring devices with variable input impedances are used. As it can be seen from Fig. 6, the conventional sensing device have strong dependence on input impedance variation of measuring devices. Both amplitude and phase of signal are affected. However, the signal phase affecting is critical in the analyzed frequency range from 10Hz to 100 Hz. The proposed sensing device can be used together with all types measuring devices without any additional reconfiguration during impedance mismatch. Thus, the stability of signal phase and amplitude are independent on input impedance of measuring devices and undesirable phenomenas as shown in Fig. 6 are minimized.

The harvesting system is optimized for wide bandwidth low power applications, has an extremely high gain-bandwidth to power ratio and is unity gain stable. Thus, the system frequency response does not affect output signal from sensing device. Due to the cable connection additional parasitic load capacitances at the output of sensing device may occur. Its size dependens on many factors as type of cable, cable length etc. It cause further signal degradation. The proposed impedance matching element is designed to directly drive up to 100nF capacitive load in unity gain. Higher gain configurations tend to have better capacitive drive capability than lower gain configurations.

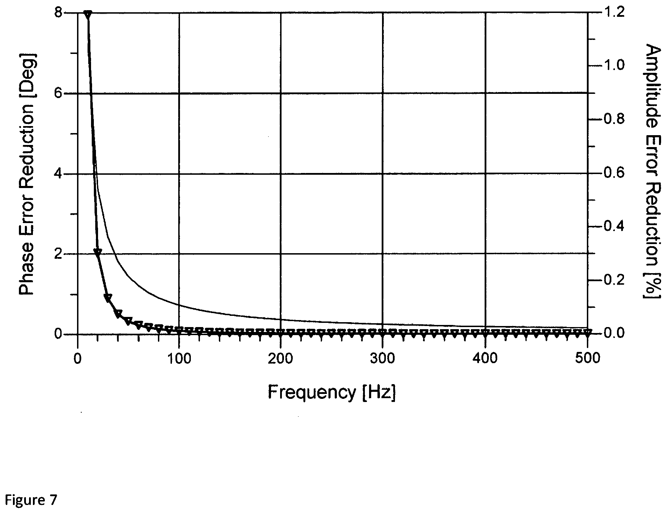

The final results in Fig.7 shows the signal integrity improvement if proposed sensing device is used. Especially at the low frequencies (below 100Hz) the error reduction is significant.

### Numbering in the figures

- 1: sensing device
- 2: insulating material
- 3: primary conductor
- 4: current sensing part
- 5: capacitive electrode
- 6: shielding electrode
- 7: capacitive electrode
- 8: capacitive electrode
- 9: harvesting system
- 10: cable connection

## Claims

1. Current and/or voltage sensing device for integrative use in electric systems, with at least one magnetic field sensor and/or at least one electric field sensor, wherein
the electric field sensor and/or the magnetic field sensor is connected to an impedance matching element, which allows connection to an independent analogue measuring device and is powered from an energy harvester, providing stable power supply to the impedance matching element, which is an integral part of an impedance matching electronic board, and wherein the energy harvester (9) is part of a cable connection (10), that connects the sensing device with the measuring device.

2. Current and/or voltage sensing device according to claim 1,
wherein the energy harvester is powered from the magnetic field and/or electric field sensor.

3. Current and/or voltage sensing device according to claim 1,
wherein the energy harvester is configured to be powered from an external power source.

4. Current and/or voltage sensing device according to any of the aforementioned claims,
wherein the impedance matching element is configured to provide an output proportional to the measured quantities, such as electric and/or magnetic field, and is independent of the input impedance of the connected device.

5. Current and/or voltage sensing device according to any of the aforementioned claims,
wherein the impedance matching element is capable of further conditioning of output signals.

6. Current and/or voltage sensing device according to any of the aforementioned claims,
wherein the impedance matching element is capable of providing a digital output.

7. Current and/or voltage sensing device according to any of the aforementioned claims,
wherein the impedance matching element is connected with an output cable of said device.

8. Current and/or voltage sensing device according to any of the aforementioned claims,
wherein the impedance matching element can be connected not only with new devices produced, but also with existing sensing devices already installed in the applications, thus suitable for retrofit purposes.

9. Current and/or voltage sensing device according to any of the aforementioned claims,
wherein the impedance matching element has internal monitoring and/or diagnostics of its functions.

10. Current and/or voltage sensing device according to claim 2,
wherein the energy harvester is powered from an electric field sensor implemented as a capacitive voltage divider.

## Patentansprüche

1. Strom- und/oder Spannungserfassungseinrichtung für die integrative Verwendung in elektrischen Systemen, mit mindestens einem Magnetfeldsensor und/oder mindestens einem Elektrisches-Feld-Sensor, wobei
der Elektrisches-Feld-Sensor und/oder der Magnetfeldsensor mit einem Impedanzanpassungselement verbunden ist, das eine Verbindung zu einer unabhängigen analogen Messeinrichtung gestattet und von einem Energy-Harvester bestromt wird, wodurch eine stabile Stromversorgung zu dem Impedanzanpassungselement bereitgestellt wird, das ein integraler Teil einer Impedanzanpassungs-Elektronikplatine ist, und wobei der Energy Harvester (9) Teil einer Kabelverbindung (10) ist, die die Erfassungseinrichtung mit der Messeinrichtung verbindet.

2. Strom- und/oder Spannungserfassungseinrichtung nach Anspruch 1,
wobei der Energy Harvester von dem Magnetfeld- und/oder Elektrisches-Feld-Sensor bestromt wird.

3. Strom- und/oder Spannungserfassungseinrichtung nach Anspruch 1,
wobei der Energy Harvester dazu ausgebildet ist, von einer externen Stromquelle bestromt zu werden.

4. Strom- und/oder Spannungserfassungseinrichtung nach einem der oben erwähnten Ansprüche,
wobei das Impedanzanpassungselement dazu ausgebildet ist, einen Ausgang proportional zu den Messgrößen bereitzustellen, wie etwa elektrisches und/oder Magnetfeld, und von der Eingangsimpedanz der angeschlossenen Einrichtung unabhängig ist.

5. Strom- und/oder Spannungserfassungseinrichtung nach einem der oben erwähnten Ansprüche,
wobei das Impedanzanpassungselement zur weiteren Konditionierung von Ausgangssignalen in der Lage ist.

6. Strom- und/oder Spannungserfassungseinrichtung nach einem der oben erwähnten Ansprüche,
wobei das Impedanzanpassungselement zum Liefern eines digitalen Ausgangs in der Lage ist.

7. Strom- und/oder Spannungserfassungseinrichtung nach einem der oben erwähnten Ansprüche,
wobei das Impedanzanpassungselement mit einem Ausgangskabel der Einrichtung verbunden ist.

8. Strom- und/oder Spannungserfassungseinrichtung nach einem der oben erwähnten Ansprüche,
wobei das Impedanzanpassungselement nicht nur mit neuen hergestellten Einrichtungen verbunden werden kann, sondern auch mit bereits in den Anwendungen installierten existierenden Erfassungseinrichtungen, somit geeignet für Nachrüstungszwecke.

9. Strom- und/oder Spannungserfassungseinrichtung nach einem der oben erwähnten Ansprüche,
wobei das Impedanzanpassungselement ein internes Monitoring und/oder Diagnose seiner Funktionen aufweist.

10. Strom- und/oder Spannungserfassungseinrichtung nach Anspruch 2, wobei der Energy Harvester von einem Elektrisches-Feld-Sensor bestromt wird, der als ein kapazitiver Spannungsteiler umgesetzt ist.

## Revendications

1. Dispositif de détection de courant et/ou de tension pour une utilisation par intégration dans des systèmes électriques, avec au moins un capteur de champ magnétique et/ou au moins un capteur de champ électrique, dans lequel
le capteur de champ électrique et/ou le capteur de champ magnétique sont branchés à un élément d'adaptation d'impédance, qui permet un branchement à un dispositif de mesure analogique indépendant et est alimenté à partir d'un dispositif de collecte d'énergie, fournissant une alimentation électrique stable à l'élément d'adaptation d'impédance, qui fait partie intégrante d'une carte électronique d'adaptation d'impédance, et dans lequel le dispositif de collecte d'énergie (9) fait partie d'un branchement par câble (10), qui branche le dispositif de détection au dispositif de mesure.

2. Dispositif de détection de courant et/ou de tension selon la revendication 1,
dans lequel le dispositif de collecte d'énergie est alimenté à partir du capteur de champ magnétique et/ou de champ électrique.

3. Dispositif de détection de courant et/ou de tension selon la revendication 1,
dans lequel le dispositif de collecte d'énergie est configuré pour être alimenté à partir d'une source d'alimentation externe.

4. Dispositif de détection de courant et/ou de tension selon l'une quelconque des revendications susmentionnées,
dans lequel l'élément d'adaptation d'impédance est configuré pour fournir une sortie proportionnelle aux quantités mesurées, telles qu'un champ électrique et/ou magnétique, et est indépendant de l'impédance d'entrée du dispositif branché.

5. Dispositif de détection de courant et/ou de tension selon l'une quelconque des revendications susmentionnées,
dans lequel l'élément d'adaptation d'impédance peut en outre conditionner des signaux de sortie.

6. Dispositif de détection de courant et/ou de tension selon l'une quelconque des revendications susmentionnées,
dans lequel l'élément d'adaptation d'impédance peut fournir une sortie numérique.

7. Dispositif de détection de courant et/ou de tension selon l'une quelconque des revendications susmentionnées,
dans lequel l'élément d'adaptation d'impédance est branché à un câble de sortie dudit dispositif.

8. Dispositif de détection de courant et/ou de tension selon l'une quelconque des revendications susmentionnées,
dans lequel l'élément d'adaptation d'impédance peut être branché non seulement à de nouveaux dispositifs produits, mais aussi à des dispositifs de détection existants déjà installés dans les applications, convenant ainsi à des fins de mise à niveau.

9. Dispositif de détection de courant et/ou de tension selon l'une quelconque des revendications susmentionnées,
dans lequel l'élément d'adaptation d'impédance a une surveillance interne et/ou des diagnostics de ses fonctions.

10. Dispositif de détection de courant et/ou de tension selon la revendication 2,
dans lequel le dispositif de collecte d'énergie est alimenté à partir d'un capteur de champ électrique mis en œuvre sous la forme d'un diviseur de tension capacitif.
